# EUROPEAN PATENT APPLICATION

(11) **EP 2 395 134 A1**
(43) Date of publication of application: **14.12.2011**
(21) Application number: 09839702.9
(22) Date of filing: 13.11.2009
(51) Int. Cl.: C30B 29/38, C30B 31/20, H01L 21/205, H01L 33/32

(54) **GaN SUBSTRATE AND METHOD OF ITS MANUFACTURE, METHOD OF MANUFACTURING GaN LAYER-BONDED SUBSTRATE AND METHOD OF MANUFACTURING SEMICONDUCTOR DEVICE**

(30) Priority: 04.02.2009 JP 2009023775
(71) Applicant: Sumitomo Electric Industries, Ltd., Chuo-ku Osaka-shi Osaka 541-0041 (JP)
(72) Inventor: HACHIGO, Akihiro, Itami-shi Hyogo 664-0016 (JP)
(74) Representative: Grünecker, Kinkeldey, Stockmair & Schwanhäusser
(86) International application number: PCT/JP2009/069350
(87) International publication number: WO 2010/089928

(57) **Abstract**

The present invention makes available a GaN substrate, and a method of its manufacture, that, with minimal machining allowances, facilitates consistent machining, and makes available a method of manufacturing a GaN layer-bonded substrate, and a semiconductor device, utilizing the GaN substrate. A GaN substrate 20 of the present invention includes a first region 20j and a second region 20i that has a higher Ga/N atomic ratio than that of the first region 20j; wherein the second region 20i widens from a depth *D -* Δ*D* to a depth *D* + Δ*D* centered about a predetermined depth *D* from one major surface 20m, the difference between the Ga/N atomic ratio at the depth *D* and the Ga/N atomic ratio at a depth *D* + 4Δ*D* or greater in the first region 20j being three times the difference between the Ga/N atomic ratio at the depth *D* + Δ*D* and the Ga/N atomic ratio at the depth *D +* 4Δ*D* or greater in the first region 20j, and wherein the ratio of the Ga/N atomic ratio in the second region 20i to the Ga / N atomic ratio at the depth *D* + 4Δ*D* or greater in the first region 20j is at least 1.05.

## Description

### Technical Field

The present invention relates to GaN substrates excelling in machinability, to methods of their manufacture, and to GaN layer-bonded substrates and semiconductor device manufacturing methods utilizing such GaN substrates.

### Background Art

GaN substrates, to be employed in the manufacture of semiconductor devices such as light-emitting devices and microelectronic devices, are machined by techniques including slicing, cutting, grinding and/or polishing. Japanese Nat'l. Stage Unexamined Pat. App. Pub. No. 2003-527296 (Patent Reference 1), for example, discloses creating GaN wafers by using an inner-diameter saw, outer-diameter saw, or most preferably a wire saw to slice GaN boules (bulk crystal).

### Citation List

### Patent Literature

PTL 1: Japanese Nat'l. Stage Unexamined Pat. App. Pub. No. 2003-527296

### Summary of Invention

### Technical Problem

Because GaN substrates are a brittle material, however, problems with the above-cited Japanese Nat'l. Stage Unexamined Pat. App. Pub. No. 2003-527296 (Patent Literature 1) have been that the machining allowances are considerable, and at the same time consistent machining has proven challenging.

In order to solve the above-noted problems, an object of the present invention is to make available a GaN substrate, and method of its manufacture, that, with minimal machining allowances, facilitates consistent machining, and make available a method of manufacturing a GaN layer-bonded substrate, and a semiconductor device, utilizing the GaN substrate.

### Solution to Problems

The present invention is a GaN substrate including: a first region; and a second region, having a higher Ga/N atomic ratio than that of the first region, that widens from a depth *D - ΔD* to a depth *D + ΔD* centered about a predetermined depth *D* from one of the major surfaces: wherein the difference between the Ga/N atomic ratio at the depth *D* and the Ga/N atomic ratio at a depth *D* + 4Δ*D* or greater in the first region is three times the difference between the Ga/N atomic ratio at the depth *D* + Δ*D* and the Ga/N atomic ratio at the depth *D* + 4Δ*D* or greater in the first region, and the ratio of the Ga/N atomic ratio in the second region to the Ga/N atomic ratio at the depth *D* + 4Δ*D* or greater in the first region is at least 1.05.

In a GaN substrate according to the present invention, the ratio of the Ga atomic fraction of the second region to the Ga atomic fraction at a depth *D* + 4Δ*D* or greater in the first region may be made at least 1.05. Also, the ratio of the N atomic fraction of the second region to the N atomic fraction at a depth *D* + 4Δ*D* or greater in the first region may be made 0.94 or lower. Further, the Ga atomic fraction and the N atomic fraction of the second region may be different from the Ga atomic fraction and the N atomic fraction at a depth *D* + 4Δ*D* or greater in the first region. Also, the second region may include ions or atoms from an element other than Ga or N, or else electrons. Further, the second region can be a strained region having crystal strain, wherein the substrate can be split in the second region by the application of external energy. In this case, the energy may be at least one of thermal energy, electromagnetic wave energy, light energy, dynamic energy, and fluid energy.

The present invention is also a method of manufacturing a GaN substrate that includes a first region and also a second region having a Ga/N atomic ratio that is higher than that of the first region, wherein by implantation of ions, atoms, or electrons, or by laser irradiation, through one of the major-surface sides the second region is formed, which widens from a depth *D -* Δ*D* to a depth *D* + Δ*D* about the center at a predetermined depth *D* from the major surface, and which has a Ga/N atomic ratio that is at least 1.05 times the Ga/N atomic ratio prior to the above-noted implantation or irradiation.

In a method of manufacturing a GaN substrate of the present invention, the ratio of the Ga atomic fraction in the second region to the Ga atomic fraction prior to the above-noted implantation or irradiation may be made 1.05 or greater. Also, the ratio of the N atomic fraction of the second region to the N atomic fraction prior to the above-noted either implantation or irradiation may be made 0.94 or smaller.
Also, the Ga atomic fraction and the N atomic fraction in the second region may be made different from the corresponding Ga atomic fraction and N atomic fraction prior to either the above-noted implantation or irradiation.

The present invention is also a method of manufacturing a GaN layer-bonded substrate, being a GaN layer-bonded substrate in which a GaN layer and a heterosubstrate having a chemical composition different from that of the GaN layer are bonded together, furnished with: a first step of preparing an above-described GaN substrate; a second step of bonding the heterosubstrate to the major surface of the GaN substrate; and a third step of obtaining a GaN layer-bonded substrate by splitting the GaN substrate in the second region to form bonded thereto a GaN layer atop the heterosubstrate.

The present invention is also a method of manufacturing a semiconductor device, furnished with a step of preparing a GaN layer-bonded substrate obtained by the above-noted manufacturing method, and a step of forming, on the GaN layer of the GaN layer-bonded substrate, an at least single-lamina III nitride semiconductor epitaxial layer.

### Advantageous Effects of Invention

The present invention makes available a GaN substrate, and method of its manufacture, that, with minimal machining allowances, facilitates consistent machining, and makes available a method of manufacturing a GaN layer-bonded substrate, and a semiconductor device, utilizing such a GaN substrate.

### Brief Description of Drawings

FIG. 1 is a simplified cross-sectional view showing one embodiment of a GaN substrate according to the present invention.
FIG. 2 is a graph showing the profile of Ga / N atomic ratio in a GaN substrate according to the present invention.
FIG. 3 is a simplified cross-sectional view showing the one embodiment of a method of manufacturing a GaN layer-bonded substrate according to the present invention, in which (a) shows the first step, (b) shows the second step, and (c) shows the third step.
FIG. 4 is a simplified cross-sectional view showing an example of a semiconductor device obtained by the method of manufacturing a semiconductor device according to the present invention.
FIG. 5 is a simplified cross-sectional view showing an example of a typical semiconductor device.

### Description of Embodiments

### Embodiment 1

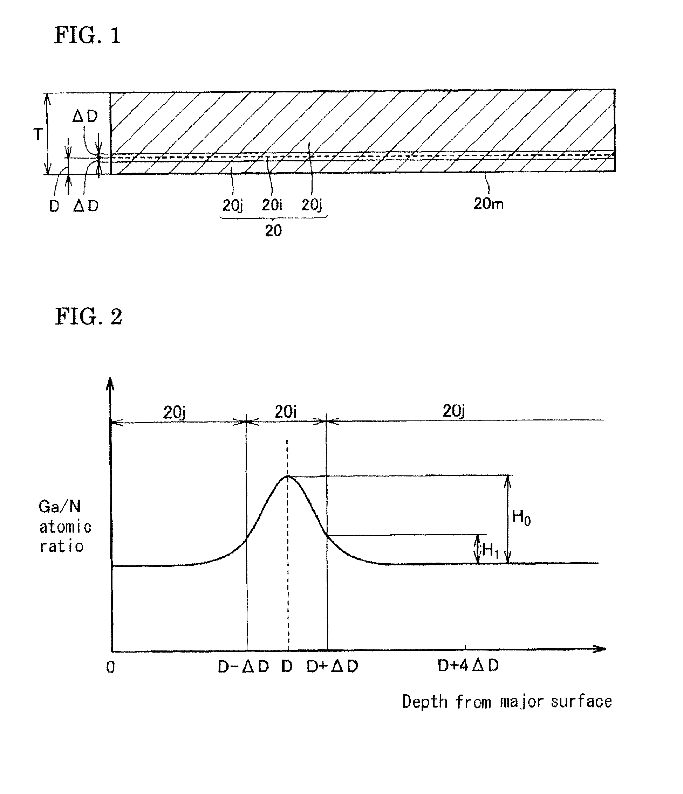

Referring to FIG. 1 and FIG. 2, an embodiment of a GaN substrate according to the present invention has a first region 20j and a second region 20i, which has a Ga/N atomic ratio that is higher than that of the first region 20j, the second region 20i widening from a depth *D -* Δ*D* to a depth *D* + Δ*D* centered about a predetermined depth *D* from one major surface 20m, where the difference between the Ga/N atomic ratio at the depth *D* in the second region 20i and the Ga/N atomic ratio at the depth *D* + 4Δ*D* or greater in the first region 20j is 3 times the difference between the Ga/N atomic ratio at the depth *D* + Δ*D* and the Ga/N atomic ratio at the depth *D* + 4Δ*D* or greater, and where the ratio of the Ga/N atomic ratio of the second region 20i to the Ga/N atomic ratio at a depth *D* + 4Δ*D* or greater in the first region 20j is at least 1.05.

In this case, the Ga/N atomic ratio in the above-noted part of the GaN substrate is the ratio of the Ga atomic fraction to the N atomic fraction in that part. Also, the Ga atomic fraction and the N atomic fraction in that part can be measured from the surface or a cross-section using AES (Auger electron spectroscopy).

Because in this embodiment of a GaN substrate 20 the Ga/N atomic ratio in the second region 20i is at least 1.05 times the Ga/N atomic ratio at a depth *D* + 4Δ*D* in the first region 20j, the second region 20i has less mechanical strength than the first region 20j and is easier to machine. For this reason, the GaN substrate 20 can be easily split in the second region 20i by externally applied energy. Also, the second region 20i in each GaN layer 20a split from the GaN substrate 20 and the remaining GaN substrate 20b is easy to polish and/or etch.

From the standpoint of facilitating the above-noted machining of the GaN substrate, it the ratio of the Ga / N atomic ratio of the second region 20i to the Ga / N atomic ratio at a depth *D* + 4Δ*D* or greater in the first region 20j is preferably at least 1.10, more preferably at least 1.15, and yet more preferably at least 1.20. And from the standpoint of restoring the crystalline properties of the GaN substrate, the above-noted ratio is preferably no greater than 5.00 and more preferably no greater than 3.00.

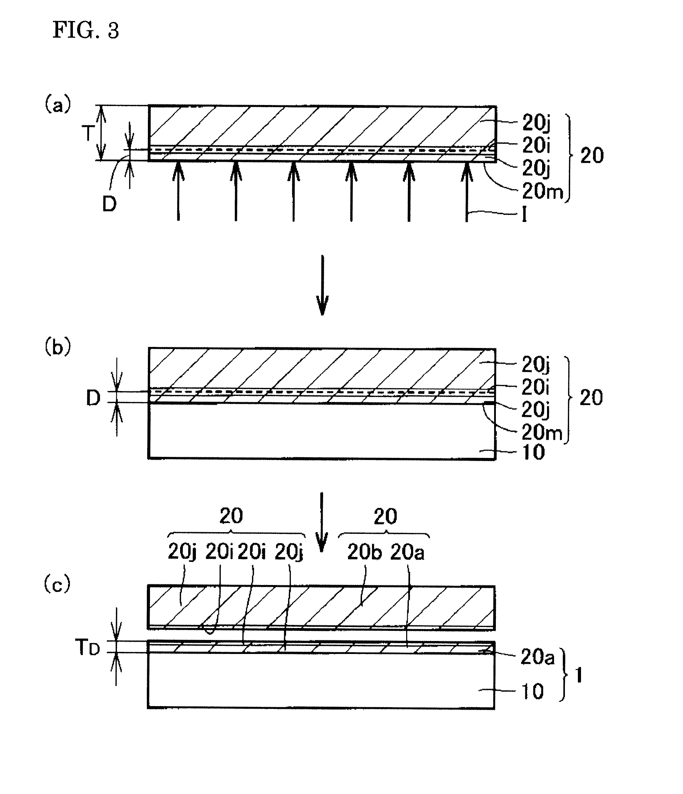

The GaN substrate 20 of this embodiment can be manufactured by changing the chemical composition (specifically, the Ga and/or N atomic fraction) of the second region 20i so that the ratio of the Ga/N atomic ratio of the second region 20i to the Ga/N atomic ratio at a depth *D* + 4Δ*D* or greater in the first region 20j is at least 1.05. Although the method for changing the Ga and/or N atomic fraction of the second region 20i is not particular restricted, methods include, for example referring to FIG. 3(a), implantation of ions or atoms of an element other than Ga or N, or else of electrons, or irradiation by a laser, is done to a predetermined depth *D* from one major surface 20m of the GaN substrate 20 (FIG. 3(a) showing ion-, atom-, or electron-implantation or laser irradiation as I).

Referring to FIG. 2, in the GaN substrate 20 of this embodiment, the second region 20i formed by either the above-noted method of implantation of ions or atoms, or else electrons, or the method of irradiation by a laser widens from the depth *D -* Δ*D* to the depth *D* + Δ*D,* centered on the depth *D* from the major surface 20m. In the second region 20i, the Ga / N atomic ratio is maximum at a depth *D* from the major surface 20m, and exhibits substantially a normal distribution in the depth direction. The difference H₀ between the Ga/N atomic ratio at the depth *D* in the second region 20i and the Ga / N atomic ratio at the depth *D* + 4Δ*D* or greater in the first region is 3 times the difference H₁ between the Ga / N atomic ratio at the depth *D* + Δ*D* and the Ga/N atomic ratio at the depth *D* + 4Δ*D* or greater in the first region.

Although there is no particular restriction regarding the depth *D* at which the second region 20i is formed, from the standpoint of controlling splitting of the substrate, it is preferably at least 0.1 µm and not exceeding 100 µm, and more preferably at least 0.2 µm and not exceeding 50 µm. Also, although the depth ΔD differs depending upon the ion-, atom- or electron-implantation method, or the laser irradiation method, the general depth is at least 0.05D and not exceeding 1D.

In the GaN substrate of this embodiment, the ratio of the Ga/N atomic ratio at a depth *D*+Δ4D or greater in the first region to the Ga/N atomic ratio in the second region is used as the comparison standard because, at a depth *D+*Δ4D or greater in the first region, the chemical composition is assumed to be almost unchanged by the above-noted implantation or irradiation.

In the GaN substrate 20 of this embodiment, from the standpoint of lowering the mechanical strength of and improving the machinability of the second region 20i, the ratio of Ga atomic fraction of the second region 20i to the Ga atomic fraction at a depth *D* + 4Δ*D* or greater in the first region 20j is preferably at least 1.05, more preferably at least 1.07, and yet more preferably at least 1.10. From the standpoint of restoring the crystalline properties of the GaN substrate, this ratio is preferably no greater than 3.00 and more preferably no greater than 2.00. The ratio between the Ga atomic fraction at a depth *D* + 4Δ*D* or greater in the first region to the Ga atomic fraction in the second region is used as the standard of comparison because, at a depth *D* + 4Δ*D* or greater in the first region, the chemical composition is assumed to be almost unchanged by the above-noted implantation or irradiation.

Also, in the GaN substrate 20 of this embodiment, from the standpoint of lowering the mechanical strength of the second region 20i to enhance the ease of machining, the ratio of the N atomic fraction in the second region 20i to the N atomic fraction at a depth *D* + 4Δ*D* or greater in the first region 20j is preferably no greater than 0.94, more preferably no greater than 0.93, and yet more preferably no greater than 0.92. And from the standpoint of restoring the crystalline properties of the GaN substrate, the above-noted ratio is preferably at least 0.40, and more preferably at least 0.50. The ratio between the N atomic fraction at a depth *D*+Δ4D or greater in the first region to the N atomic fraction in the second region is used as the standard of comparison because, at a depth *D*+Δ4D or greater in the first region, the chemical composition is assumed to be almost unchanged by the above-noted implantation or irradiation.

In the GaN substrate 20 of this embodiment, from the standpoint of lowering the mechanical strength and improving the ease of machining of the second region 20i, it is preferable that the ratio Ga atomic fraction and the N atomic fraction in the second region 20i are each different from the Ga atomic fraction and the N atomic fraction at a depth *D* + 4Δ*D* or greater in the first region 20j.

In the GaN substrate 20 of this embodiment, the second region 20i is a strained region that has a crystalline strained region, which can be split in the second region 20i by the external application of energy. Although it is not particularly restricted, from the standpoint of applying the energy uniformly over the surface, energy in this case may be at least one of thermal energy, electromagnetic wave energy, light energy, mechanical energy, and fluid energy that is imparted by a flow of fluid.

The crystal strain in the second region 20i can be evaluated with regard to a prescribed X-ray diffraction peak in the second region 20i, by the difference between the position of an X-ray diffraction peak in the second region 20i and that X-ray diffraction peak in the first region.

### Embodiment 2

Referring to FIG. 1 and FIG. 3(a), one embodiment of a method of manufacturing a GaN substrate according to the present invention is a method of manufacturing GaN substrate of the first embodiment, which includes a first region 20j and also a second region 20i that has a high Ga/N atomic ratio compared with the first region 20j, wherein by implanting ions, atoms, or electrons, or causing light from a laser to strike from the side of one major surface 20m (refer to I in FIG. 3(a)), a second region 20i is formed, which widens from a depth *D -* Δ*D* to a depth *D* + Δ*D* about the center at a predetermined depth *D* from the major surface 20m, and which has a Ga/N atomic ratio of at least 1.05 times the Ga/N atomic ratio before either the implantation or irradiation.

Because the chemical composition of the second region 20i is different, so that the Ga/N atomic ratio thereof is at least 1.05 times the Ga/N atomic ratio at a depth *D* + 4Δ*D* in the first region 20j, in the GaN substrate 20 manufactured in this manner the second region 20i has less mechanical strength than the first region 20j and more easily machined. For this reason, the GaN substrate 20 can be easily split in the second region 20i by externally applied energy. Also, the second region in each GaN layer 20a split from the GaN substrate 20 and the remaining GaN substrate 20b is easy to polish and/or etch.

From the standpoint of making the above-noted GaN substrate easer to machine, the ratio of the Ga / N atomic ratio of the second region 20i to the Ga / N atomic ratio before implantation or irradiation is preferable at least 1.10, more preferably at least 1.15, and yet more preferably at least 1.20. And from the standpoint of restoring the crystalline properties of the GaN substrate, this ratio is preferably no greater than 5.00 and more preferably no greater than 3.00.

Although there is no particular restriction on the method of implanting ions, atoms, or electrons through the one major surface 20m, methods include ion implantation and plasma gas implantation. Although the implanted atomic elements are not particular restricted, examples that may be given include H (hydrogen), He (helium), N (nitrogen), Ne (neon), and Ar (argon). Although the depth from the surface through which the above-noted elemental ions or atoms, or else electrons are implanted is not particularly restricted, from the standpoint of controlling the splitting, the depth is preferably at least 0.1 µm and no greater than 30 µm. Also, from the standpoint of ease of implanting the above-noted elemental ions or atoms, or else electrons, the implanted depth *D* thereof is preferably at least 0.1 µm and no greater than 10 µm, and more preferably at least 0.3 µm and no greater than 2 µm. Therefore, the method of implanting the above-noted elemental ions or atoms, or else electrons is superior as a method of forming a second region 20i having a Ga/N atomic ratio that is at least 1.05 times the Ga/N atomic ratio of the first region 20j to a depth D that is a small distance from the one major surface 20m (that is, one that is shallow). Also, although the depth ΔD differs depending upon the implantation method and the particle type- the above-noted elemental ions or atoms, or else electrons, the general depth is at least 0.05D and not exceeding 1D.

Although there is no particular restriction regarding the method of causing a laser to strike from one side of the major surface 20m, the methods include such methods as that of causing a high-energy laser beam to strike at short time, using a femtosecond or picosecond laser. The depth from the surface, which is the focus of the laser light, although not particularly restricted, from the standpoint of controlling the splitting, is preferably 1 µm or greater and not greater than 200 µm. Additionally, from the standpoint of achieving small surface damage and easy control of the focus of the laser, the depth D of the focus point of the laser irradiation is preferably at least 5 µm and not greater than 150 µm, and more preferably at least 10 µm and not greater than 100 µm. Therefore, the method of radiating with a laser is superior as a method of forming a second region 20i having a Ga/N atomic ratio that is at least 1.05 times the Ga/N atomic ratio at a depth *D* + 4Δ*D* in the first region 20j to a depth D that is a large distance (i.e., deep) from the one major surface 20m. Also, although the depth ΔD differs depending upon the laser irradiation method, the general depth is at least 0.05D and not exceeding 1D.

In the method of manufacturing a GaN substrate of this embodiment, from the standpoint of lowering the mechanical strength of the second region 20i and improving its ease of machining, the ratio of the Ga atomic fraction of the second region 20i to the Ga atomic fraction before the above-noted implantation or irradiation is preferably at least 1.05, more preferably at least 1.07, and yet more preferably at least 1.10. Also, from the standpoint of restoring the crystalline properties of the GaN substrate, this ratio is preferably no greater than 3.00 and more preferably no greater than 2.00.

In the method of manufacturing a GaN substrate of this embodiment, from the standpoint of lowering the mechanical strength of the second region 20i and improving its ease of machining, the ratio of the N atomic fraction of the second region 20i to the N atomic fraction before the above-noted implantation or irradiation is preferably no greater than 0.94, more preferably no greater than 0.93, and yet more preferably no greater than 0.92. Also, from the standpoint of restoring the crystalline properties of the GaN substrate, this ratio is preferably at least 0.40 and more preferably at least 0.50.

In the method of manufacturing a GaN substrate of this embodiment, from the standpoint of lowering the mechanical strength of the second region 20i and improving its ease of machining, it is preferable that the Ga atomic fraction and N atomic fraction of the second region 20i each be different from the Ga atomic fraction and the N atomic fraction before the above-noted implantation or irradiation.

### Embodiment 3

Referring to FIG. 3, an embodiment of a method of manufacturing a GaN layer-bonded substrate according to the present invention, in which the GaN layer bonded substrate in which a GaN layer 20a is bonded to a substrate 10 of a different kind having a chemical composition different from that of the GaN layer 20a (FIG. 3(a)), has a first step of preparing a GaN substrate 20 according to the first embodiment, , a second step of bonding the heterosubstrate 10 to the major surface 20m of the GaN substrate 20 (FIG. 3(b)), and a third step of splitting the GaN substrate 20 in the second region 20i and forming a GaN layer 20a bonded to the heterosubstrate 10 to obtain GaN layer-bonded substrate1 (FIG. 3(c)).

The method of manufacturing the GaN layer-bonded substrate of this embodiment, by having the above-noted first to third steps, bonds the heterosubstrate 10 without causing damage to the GaN substrate 20, and uniformly splits the GaN substrate 20 with a small amount of allowance for splitting of the second region 20i, thereby obtaining with high yield, a GaN layer-bonded substrate wherein the GaN layer 20a is bonded to the heterosubstrate 10. Each step is described in detail below.

### First Step

Referring to FIG. 3(a), the method of manufacturing a GaN layer-bonded substrate of this embodiment has a first step of preparing a GaN substrate 20 of the first embodiment. The GaN substrate 20 of the first embodiment can be prepared by manufacturing in accordance with the method of manufacturing the GaN substrate 20 of the second embodiment. By the first step, an easy-to-split GaN substrate is obtained with a small amount of allowance for splitting in the second region 20i.

### Second Step

Referring to FIG. 3 (b), The method of manufacturing a GaN layer-bonded substrate of this embodiment has a second step of bonding the heterosubstrate 10 to a major surface 20m of the GaN substrate 20. By this second step, the heterosubstrate 10 is bonded to the GaN substrate 20.

Although the method of bonding the heterosubstrate 10 to the major surface 20m of the GaN substrate 20 is not particularly restricted, from the standpoint of maintaining the bonding strength at high temperatures after bonding, preferable methods include the direct bonding method, in which the surfaces to be bonded are cleaned and directly stuck together and the temperature is raised to approximately 600°C to 1200°C to bond them together, and the surface activation bonding method, in which a surface to be bonded is activated by using a plasma or ions or the like, and bonding is done at a low temperature from room temperature (for example 10 °C to 30 °C) to approximately 400 °C. Other methods that may be used include a method of applying an adhesive to the GaN substrate 20 and/or the heterosubstrate 10, and a method of eutectic bonding by interposing metal at the bonding interface between the GaN substrate 20 and the heterosubstrate 10 and raising the temperature.

Although the heterosubstrate 10 to be bonded to the major surface 20m of GaN substrate 20 is not particular restricted, from the standpoint of withstanding the environment in which a Group III nitride semiconductor epitaxial layer is grown on the GaN layer 20a of the manufactured GaN layer-bonded substrate 1, the thermal resistance temperature is preferably at least 1200°C, and it is preferable that there be corrosion resistance even at above 1200°C. In this case, the term corrosion resistance refers to not being corroded by corrosive crystal growth atmospheres, such as hydrochloric acid (HCl) gas, or ammonia (NH₃) gas and the like. From this standpoint, preferable heterosubstrates include at sapphire substrate, an AIN substrate, an SiC substrate, a ZnSe substrate, an Si substrate, an Si substrate on which is formed an SiO₂ layer, a ZnO substrate, a ZnS substrate, a silica, substrate, a carbon substrate, a diamond substrate, a Ga₂O₃ substrate, and a ZrB₂ substrate.

### Third Step

Referring to FIG. 3(c), the method of manufacturing a GaN layer-bonded substrate of this embodiment has a third step of splitting the GaN substrate 20 in the second region 20i and forming a GaN layer 20a bonded onto the heterosubstrate 10, so as to obtain the GaN layer-bonded substrate 1. By this third step, in the second region 20i of the GaN substrate 20, splitting into the GaN layer 20a to which the heterosubstrate 10 is bonded and the remaining GaN substrate 20b is carried out. In this manner, the GaN layer-bonded substrate 1 is obtained, in which the GaN layer 20a, having a thickness of *T_{D},* is bonded to the heterosubstrate 10.

As long as it is a method of externally applying some form of energy, there is no particular restriction on the method of splitting the GaN substrate 20 in the second region 20i. From the standpoint of ease of splitting, the energy externally applied is preferably at least one of thermal energy, electromagnetic wave energy, light energy, mechanical energy, and fluid energy.

In this case, the second region 20i has a widening from a depth *D -* Δ*D* to a depth *D* + Δ*D* from the one major surface 20m of the GaN substrate 20, the ion, atom, or electron implantation dose, or laser irradiation amount and the Ga/N atomic ratio being maximum in the region from a depth *D* from the major surface 20m (surface region), it being easy to reduce the mechanical strength in this region. Therefore, splitting is done in the GaN substrate 20, usually in a region (surface region) at the depth *D* from the one major surface 20m of the GaN substrate 20 or in the proximity thereof. The value of the thickness *T_{D}* of the GaN layer 20a, therefore, is close to the depth *D*, and is a value between the depth *D -* Δ*D* and the depth *D* + Δ*D.*

### Embodiment 4

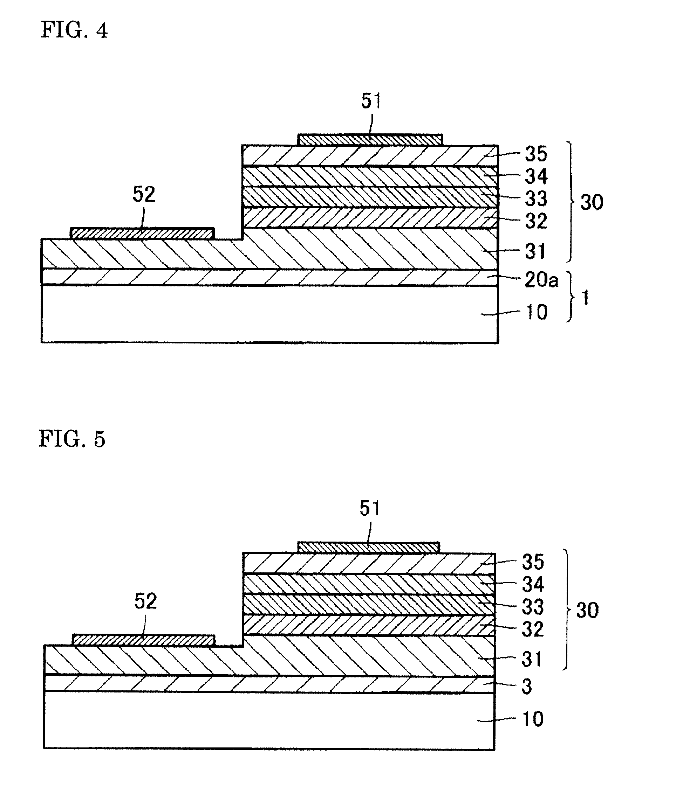

Referring to FIG. 4, an embodiment of a method of manufacturing a semiconductor device according to the present invention has as step of preparing a GaN layer-bonded substrate 1 obtained by the method of manufacturing of the third embodiment, and a step of forming an at least single-lamina III nitride semiconductor epitaxial layer 30 on the GaN layer 20a of the GaN layer-bonded substrate 1.

By having the step, because the method of manufacturing a semiconductor device of this embodiment forms an at least single-lamina III nitride semiconductor epitaxial layer 30 having high crystallinity is on the major surface of the GaN layer 20a of the GaN layer-bonded substrate 1, while suppressing transition caused the difference in thermal coefficient expansion and maintaining the crystalline properties of the GaN layer 20a, a semiconductor device having superior characteristics is obtained.

Although there is no particular restriction on the method of forming an at least single-lamina III nitride semiconductor epitaxial layer 30, from the standpoint of obtaining a high-quality Group III nitride semiconductor epitaxial layer 30, the MOCVD method, the HVPE method, and the MBE method and the like are preferable.

Specifically, referring to FIG. 4, MOCVD is used to form onto the major surface of the of the GaN layer 20a of the GaN layer-bonded substrate 1 as a Group III nitride semiconductor epitaxial layer 30, the growth being in the sequence of an *n*-type GaN layer 31, an *n*-type AlₛGa₁₋ₛN layer 32, a light-emitting layer 33 with a MQW (multi-quantum well) formed by an InᵤGa₁₋ᵤN layer and an InᵥGa₁₋ᵥN layer, a *p*-type AlₜGa₁₋ₜN layer 34, and a *p*-type GaN layer 35. Next, mesa etching is done to expose a part of the surface of the *n*-type GaN layer 31. Next, vacuum evaporation deposition or electron beam deposition is done to form a *p*-side electrode 51 on the *p*-type GaN layer 35 and form an *n-*side electrode 52 on the exposed surface of the *n*-type GaN layer 31. In this manner, a light-emitting device with good characteristics is obtained as a Group III nitride semiconductor device.

### Examples

### Reference Example 1

A hexagonal crystal GaN wafer having been grown by the HVPE method and having a diameter of 2 inches (5.08 cm) and thickness of 400 µm was polished using a diamond abrasive, and a GaN substrate having a verified scratch was prepared, seven GaN substrates each divided into quarters being prepared. Of these GaN substrates, six divided GaN substrates were immersed in hydrochloric acid of 35% by mass. The immersion times for two each of the divided GaN substrates were 5 minutes, 15 minutes, and 30 minutes, respectively. The six divided GaN substrates, after the above-noted immersion in hydrochloric acid, were rinsed in pure water and dried by blowing nitrogen on them. After the above-noted cleaning by hydrochloric acid immersion, the scratches on the divided GaN substrates were verified by microscope observation to be approximately the same as before cleaning with hydrochloric acid.

Next, AES (Auger electron spectroscopy) was used to measure the Ga atomic fraction and the N atomic fraction at a proximity of the Ga surface, which is one major surface of one of two divided GaN substrates that had been cleaned with hydrochloric acid and a surface on which etching had been done by Ar ions to 1 µm from the Ga surface, in order to calculate the Ga/N atomic ratio (ratio of the Ga atomic fraction to the N atomic fraction, the same will be apply hereinafter). Next, the Ga/N atomic ratio [(Ga/N)₂] in the proximity of the surface with respect to the Ga/N atomic ratio [(Ga/N)₁] at the Ar ion etched surface, this being [(Ga/N)₂] /[(Ga/N)₁], was calculated. The ratio of the Ga atomic fraction [(Ga)₂] in the proximity of the surface to the Ga atomic fraction [(Ga)₁] in the Ar ion etched surface, this being [(Ga)₂]/[(Ga)₁], and the ratio of the N atomic fraction [(N)₂] in the proximity of the surface to the N atomic fraction [(N)₁] in the Ar ion etched surface, this being [(N)₂]/[(N)₁] were also calculated.

Also, of two divided GaN substrates that had been cleaned with hydrochloric acid, the surface of the remaining one divided GaN substrate, and the above-noted one divided GaN substrate that had not been cleaned with hydrochloric acid were mechanically polished using a diamond abrasive with a particle size of 1 µm, and the amount of time required to polish until scratches were removed was measured, the surface roughnesses *Ra* at that time being measured. The surface roughness *Ra* as used herein is the calculated roughness average *Ra* stipulated in JIS B 0601, this being defined as the summed and averaged values, sampling from a roughness profile a reference length in a direction along a mean line of the profile, of the distances (absolute values of the deviations) from a mean line of the sampled section to the measured curve. The surface roughness *Ra* was measured over a range of 200 µm square, using an optical interferometer type of profilometer. The results are summarized in Table I.

**Table I**

| Hydrochloric immersion time (min) | [(Ga/N)₂]/[(Ga/N)₁] | [(Ga)₂]/[(Ga)₁] | [(N)₂] [(N)₁] | Polish time (mim) | Surface roughness *Ra*(nm) |
|---|---|---|---|---|---|
| --- | 1.00 | 1.00 | 1.00 | 37 | 1.18 |
| 5 | 1.04 | 1.01 | 0.97 | 34 | 1.16 |
| 15 | 1.12 | 1.05 | 0.94 | 29 | 1.05 |
| 30 | 1.14 | 1.06 | 0.93 | 28 | 1.03 |

As is clear from Table I, GaN substrates in which [(Ga/N)₂]/[(Ga/N)₁] is 1.05 or greater and also preferably in which [(Ga)₂]/[(Ga)₁] is 1.05 or greater or [(N)₂]/[(N)₁] is no greater than 0.94 had short polishing times and a small surface roughness *Ra*, and had improved ease of machining.

### Example 1

Four oxygen-doped GaN substrates having diameters of 2 inches (5.08 cm) and thicknesses of 2000 µm, with both surfaces polished to a mirror-like surface were prepared. The GaN substrates were hexagonal crystals, with one major surface thereof being a Ga surface ((0001) plane). The GaN substrates had a resistivity of 1 Ω-cm or lower and a carrier density of 1 × 10¹⁷ cm⁻³ or greater. The resistivity and carrier density were measured using a Hall-effect measuring apparatus.

Femtosecond laser light was directed onto the Ga surface of the above-noted GaN substrates. The laser focus point was adjusted to 70 µm from the Ga surface. The power of the femtosecond laser was set to 2 µJ, 5 µJ, and 10 µJ. One GaN substrate not subjected to laser light was taken as a reference. Under optical microscope observation, at all of the power levels, there was no cutting by melting.

Each of the GaN substrates was divided and AES used on the cross-sections, the ratio of the Ga/N atomic ratio [(Ga/N)₂] in the Ga/N atomic fraction surface proximity (the second region that is at a depth *D* + Δ*D* from the laser irradiated major surface) in the vicinity of the laser focus, with respect to the Ga/N atomic ratio [(Ga/N)₁] in the major surface that was not struck by the laser light (the first region that is at a depth *D* + 4Δ*D* or greater from the laser radiated major surface), this being [(Ga/N)₂] /[(Ga/N)₁], was calculated. The ratio of the Ga atomic fraction [(Ga)₂] in the Ga / N atomic fraction surface proximity (the second region that is at a depth *D* + Δ*D* from the laser irradiated major surface) in the vicinity of the laser focus, with respect to the Ga atomic fraction [(Ga)₁ in the major surface that was not struck by the laser light (the first region that is at a depth *D* + 4Δ*D* or greater from the laser radiated major surface), this being [(Ga)₂]/[(Ga)₁], and the ratio of the N atomic fraction [(N)₂] in the Ga/N atomic fraction surface proximity (the second region that is at a depth *D* + Δ*D* from the laser irradiated major surface) in the vicinity of the laser focus, with respect to the N atomic fraction [(N)₁] in the major surface that was not struck by the laser light (the first region that is at a depth *D* + 4Δ*D* or greater from the laser radiated major surface), this being [(N)₂] /[(N)₁] were also calculated. In all of the GaN substrates that were irradiated by laser light, [(Ga/N)₂]/ [(Ga/N)₁] was maximum at a depth *D* of approximately 50 µm from the Ga surface. The GaN substrates that were not irradiated by laser light were also cut in half and, upon performing AES on the cross section of the cut substrates, the associated Ga/N atomic ratio [(Ga/N)₀], Ga atomic fraction [(Ga)₀], and N atomic fraction [(N)₀] were uniform, and these were the same as the Ga/N atomic ratio [(Ga / N)₁], Ga atomic fraction [(Ga)₁], and N atomic fraction [(N)₁].

Also, the remaining portion of the GaN substrates (remaining GaN substrates) were diced in the region in which laser irradiation was done, using a wire saw. The relative ratio between the machining time for a GaN substrate that had been irradiated by laser light, relative to the processing time for a GaN substrate that had not been irradiated by laser light was determined, the results being summarized in Table II.

**Table II**

| Laser power (*µ*J) | [(Ga/N)₂]/[(Ga/N)₁] | [(Ga)₂]/[(Ga)₁] | [(N)₂]/[(N)₁] | Dicing-process-time relative ratio |
|---|---|---|---|---|
| --- | 1.00 | 1.00 | 1.00 | 1 |
| 2 | 1.03 | 1.01 | 0.96 | 0.96 |
| 5 | 1.13 | 1.06 | 0.94 | 0.88 |
| 10 | 1.21 | 1.11 | 0.92 | 0.81 |

As is clear from Table 2, GaN substrates in which [(Ga/N)₂]/[(Ga/N)₁] is 1.05 or greater and also preferably in which [(Ga)₂]/[(Ga)₁] is 1.05 or greater or [(N)₂]/[(N)₁] is no greater than 0.94 had shorter dicing times and improved ease of machining.

### Example 2

Three oxygen-doped GaN substrates having diameters of 2 inches (5.08 cm) and thicknesses of 300 µm, with both surfaces polished to a mirror-like surface, were prepared. The GaN substrates were hexagonal crystals, with one major surface thereof being a Ga surface ((0001) plane). The GaN substrates had a resistivity of 1 Ω-cm or lower and a carrier density of 1 × 10¹⁷ cm⁻³ or greater.

Of the above-noted GaN substrates, H ions were implanted through the Ga surface side of two GaN substrates. The H ion accelerating potential was 100 keV, and the dose was made 1 × 10¹⁷ cm⁻² or 2 × 10¹⁷ cm⁻². The GaN substrates into which H ions were implanted were cut in half, AES was performed on the cross-sections of the divided GaN substrates, and the ratio of the Ga/N atomic ratio [(Ga/N)₂] in the H ion implanted region (second region at a depth *D* + Δ*D* from the ion implantation major surface) with respect to the Ga/N atomic ratio [(Ga/N)₁] in the region without H ion implantation (first region at a depth greater than *D* + 4Δ*D* from the ion implantation major surface), this being [(Ga/N)₂]/[(Ga/N)₁], was calculated. The ratio of the Ga atomic fraction [(Ga)₂] in the H ion implanted region (second region at a depth *D* + Δ*D* from the ion implantation major surface) with respect to the Ga atomic fraction [(Ga)₁] in the region without H ion implantation (first region at a depth greater than *D* + 4Δ*D* from the ion implantation surface), this being [(Ga)₂]/[(Ga)₁], and the ratio of the N atomic fraction [(N)₂] in the H ion implanted region (second region at a depth *D* + Δ*D* from the ion implantation major surface) with respect to the N atomic fraction [(N)₁] in the region without H ion implantation (first region at a depth greater than the *D* + 4Δ*D* from the ion implantation surface), this being [(N)₂]/[(N)₁] were also calculated. In all of the GaN substrates in which H ion implantation was done, [(Ga/N)₂]/[(Ga/N)₁] was maximum at a depth of approximately 0.7 µm from the Ga surface. The GaN substrates in which H ion implantation was not done were also cut and, upon performing AES on the cross section of the cut substrate, the associated Ga/N atomic ratio [(Ga/N)₀], Ga atomic fraction [(Ga)₀], and N atomic fraction [(N)₀] were uniform, and these were the same as the Ga/N atomic ratio [(Ga/N)₁], Ga atomic fraction [(Ga)₁], and N atomic fraction [(N)₁].

Also, the other GaN substrates remaining from the above-described splitting were tested for cracks by using a Vickers indenter, applying a load of 20 gf to the H-ion implantation side. Additionally, the remaining GaN substrates were polished along the surface on the H-ion implantation side, and the polishing times until the Vickers indenter indentation disappeared were compared. The above-noted polishing times for the GaN substrate remaining after splitting the GaN substrates which had been implanted with H ions, relative to the polishing time for the GaN substrates remaining after splitting the GaN substrates which had not been implanted with H ions was calculated, the results being summarized in Table III.

**Table III**

| H-ion dose (cm⁻²) | [(Ga/N)₂]/[(Ga/N)_{1]} | [(Ga)₂]/[(Ga)₁] | [(N)₂]/[(N)₁] | Cracking presence | Polish-time-relative ratio |
|---|---|---|---|---|---|
| --- | 1.00 | 1.00 | 1.00 | Yes | 1 |
| 1×10¹⁷ | 1.04 | 1.02 | 0.98 | Yes | 0.94 |
| 2×10¹⁷ | 1.15 | 1.07 | 0.93 | No | 0.82 |

As is clear from Table III, GaN substrates in which [(Ga/N)₂]/[(Ga/N)₁] is 1.05 or greater and also preferably in which [(Ga)₂]/[(Ga)₁] is 1.05 or greater or [(N)₂]/[(N)₁] is no greater than 0.94 did not exhibit cracking, had shorter polishing times, and had improved ease of machining.

### Example 3

Three oxygen-doped GaN substrates having diameters of 2 inches (5.08 cm) and thicknesses of 300 µm, with both surfaces polished to a mirror-like surface were prepared. The GaN substrates were hexagonal crystals, with one major surface thereof being a Ga surface ((0001) plane). The GaN substrates had a resistivity of 1 Ω-cm or lower and a carrier density of 1 × 10¹⁷ cm⁻³ or greater.

Of the above-noted GaN substrates, He ions were implanted through the Ga surface side of two GaN substrates. The He ion accelerating potential was 100 keV, and the dose was made 5 × 10¹⁶ cm⁻² or 2.5 × 10¹⁷ cm⁻². The GaN substrates into which He ions were implanted were split in half, AES was performed on the cross-sections of the divided GaN substrates, and the ratio of the Ga/N atomic ratio [(Ga/N)₂] in the He ion implanted region (second region at a depth *D* + Δ*D* from the ion implantation major surface) with respect to the Ga/N atomic ratio [(Ga/N)₁] in the region without He ion implantation (first region at a depth greater than *D* + 4*ΔD* from the ion implantation major surface), this being [(Ga/N)₂]/[(Ga/N)₁], was calculated. The ratio of the Ga atomic fraction [(Ga)₂] in the He ion implanted region (second region at a depth *D* + Δ*D* from the ion implantation major surface) with respect to the Ga atomic fraction [(Ga)₁] in the region without He ion implantation (first region at a depth greater than *D* + 4Δ*D* from the ion implantation surface), this being [(Ga)₂]/[(Ga)₁], and the ratio of the N atomic fraction [(N)₂] in the He ion implanted region (second region at a depth *D* + Δ*D* from the ion implantation major surface) with respect to the N atomic fraction [(N)₁] in the region without He ion implantation (first region at a depth greater than the *D* + 4Δ*D* from the ion implantation surface), this being [(N)₂]/[(N)₁] were also calculated. In all of the GaN substrates in which He ion implantation was done, [(Ga/N)₂]/[(Ga/N)₁] was maximum at a depth of approximately 0.6 µm from the Ga surface. The GaN substrates in which He ion implantation was not done were also split and, upon performing AES on the cross section of the split substrate, the associated Ga / N atomic ratio [(Ga / N)₀], Ga atomic fraction [(Ga)₀], and N atomic fraction [(N)₀] were uniform, and these were the same as the Ga/N atomic ratio [(Ga/N)₁], Ga atomic fraction [(Ga)₁], and N atomic fraction [(N)₁].

Also, the other GaN substrates remaining from the above-described splitting were tested for cracks by using a Vickers indenter, applying a load of 20 gf to the He-ion implantation side. Additionally, the remaining GaN substrates were polished along the surface on the He-ion implantation side, and the polishing times until the Vickers indenter indentation disappeared were compared. The above-noted polishing time for the GaN substrate remaining after splitting the GaN substrates which had been implanted with He ions relative to the polishing time for the GaN substrates remaining after splitting the GaN substrate which had not been implanted with He ions was calculated, the results being summarized in Table IV.

**Table IV**

| He-ion dose (cm⁻²) | [(Ga/N)₂]/[(Ga/N)₁] | [(Ga)₂]/[(Ga)₁] | [(N)₂]/[(N)₁] | Cracking presence | Polish-time-relative ratio |
|---|---|---|---|---|---|
| --- | 1.00 | 1.00 | 1.00 | Yes | 1 |
| 5×10¹⁶ | 1.04 | 1.02 | 0.98 | Yes | 0.93 |
| 1.5×10¹⁷ | 1.17 | 1.08 | 0.92 | No | 0.79 |

As is clear from Table IV, GaN substrates in which [(Ga/N)₂]/[(Ga/N)₁] is 1.05 or greater and also preferably in which [(Ga)₂]/[(Ga)₁] is 1.05 or greater or [(N)₂]/[(N)₁] is no greater than 0.94 did not exhibit cracking, had shorter polishing times, and had improved ease of machining.

### Example 4

Three oxygen-doped GaN substrates having diameters of 2 inches (5.08 cm) and thicknesses of 300 µm, with both surfaces polished to a mirror-like surface were prepared. The GaN substrates were hexagonal crystals, with one major surface thereof being a Ga surface ((0001) plane). The GaN substrates had a resistivity of 1 Ω-cm or lower and a carrier density of 1 × 10¹⁷ cm⁻³ or greater.

Of the above-noted GaN substrates, H ions were implanted through the Ga surface side of two GaN substrates. The H ion accelerating potential was 160 keV, and the dose was made 8 × 10¹⁶ cm⁻² or 1.7 × 10¹⁷cm⁻². The GaN substrates into which H ions were implanted were split in half, AES was performed on the cross-sections of the divided GaN substrates, and the ratio of the Ga/N atomic ratio [(Ga/N)₂] in the H ion implanted region (second region at a depth *D* + Δ*D* from the ion implantation major surface) with respect to the Ga/N atomic ratio [(Ga/N)₁] in the region without H ion implantation (first region at a depth greater than *D* + 4Δ*D* from the ion implantation major surface), this being [(Ga/N)₂]/[(Ga/N)₁], was calculated. The ratio of the Ga atomic fraction [(Ga)₂] in the H ion implanted region (second region at a depth *D* + Δ*D* from the ion implantation major surface) with respect to the Ga atomic fraction [(Ga)₁] in the region without H ion implantation (first region at a depth greater than *D* + 4Δ*D* from the ion implantation surface), this being [(Ga)₂]/[(Ga)₁], and the ratio of the N atomic fraction [(N)₂] in the H ion implanted region (second region at a depth *D* + Δ*D* from the ion implantation major surface) with respect to the N atomic fraction [(N)₁] in the region without H ion implantation (first region at a depth greater than the *D* + 4Δ*D* from the ion implantation surface), this being [(N)₂]/[(N)₁] were also calculated. In all of the GaN substrates in which H ion implantation was done, [(Ga/N)₂]/[(Ga/N)₁] was maximum at a depth D of approximately 1.1 µm from the Ga surface. The GaN substrates in which H ion implantation was not done were also split in half and, upon performing AES on the cross section of the split substrate, the associated Ga / N atomic ratio [(Ga/N)₀], Ga atomic fraction [(Ga)₀], and N atomic fraction [(N)₀] were uniform, and these were the same as the Ga/N atomic ratio [(Ga/N)₁], Ga atomic fraction [(Ga)₁], and N atomic fraction [(N)₁].

Also, the other GaN substrates remaining from the above-described splitting tested for cracks by using a Vickers indenter, applying a load of 20 gf to the H-ion implantation side. Additionally, the remaining GaN substrates were polished along the surface on the H-ion implantation side, and the polishing times until the Vickers indenter indentation disappeared were compared. The above-noted polishing time for the GaN substrate remaining after splitting the GaN substrates which had been implanted with H ions relative to the polishing time for the GaN substrates remaining after splitting the GaN substrate which had not been implanted with H ions was calculated, the results being summarized in Table V.

**Table V**

| H-ion dose (cm⁻²) | [(Ga/N)₂]/[(Ga/N)₁] | [(Ga)₂]/[(Ga)₁] | [(N)₂]/[(N)₁] | Cracking presence | Polish-time-relative ratio |
|---|---|---|---|---|---|
| --- | 1.00 | 1.00 | 1.00 | Yes | 1 |
| 8×10¹⁶ | 1.04 | 1.01 | 0.97 | Yes | 0.95 |
| 1.7×10¹⁷ | 1.13 | 1.06 | 0.94 | No | 0.86 |

As is clear from Table V, GaN substrates in which [(Ga/N)₂]/[(Ga/N)₁] is 1.05 or greater and also preferably in which [(Ga)₂]/[(Ga)₁] is 1.05 or greater or [(N)₂]/[(N)₁] is no greater than 0.94 did not exhibit cracking, had shorter polishing times, and had improved ease of machining.

### Example 5

An oxygen-doped GaN substrate having a diameter of 2 inches (5.08 cm) and thicknesses of 300 µm, with both surfaces polished to a mirror-like surface was prepared. The GaN substrates were hexagonal crystals, with one major surface thereof being a Ga surface ((0001) plane). The GaN substrates had a resistivity of 1 Ω-cm or lower and a carrier density of 1 × 10¹⁷ cm⁻³ or greater.

Next, H ions were implanted through the N surface side of the above-noted GaN substrate. The accelerating potential for the H ions was 100 keV and the dose was made 7 × 10¹⁷ cm⁻².

Next, the activated N surface of the above-noted H ion implanted GaN substrate and the activated SiO₂ layer surface of an SiO₂/Si template substrate (heterosubstrate) in which a 100-nm-thick SiO₂ layer was formed on a surface of 350-µm-thick Si base substrate were bonded together. The fabrication of the SiO₂/Si template substrate was done by thermally oxidizing the surface of the SiO₂ substrate. The activating of the N surface of the H ion implanted GaN substrate and the SiO₂ layer surface of the SiO₂/Si template substrate was done by using RIE (reactive ion etching) to bring the above-noted surface in contact with a gas plasma. The gas plasma conditions were an Ar gas flow rate of 50 sccm (1 sccm means a flow measurement according to which a gas under standard conditions flows at a cubic centimeter per minute), an Ar gas atmosphere pressure of 6.7 Pa, and an RF power of 100 W. The bonding of the H ion implanted substrate with an activated N surface with the SiO₂/Si template substrate with an activated SiO₂ layer was done in a normal atmosphere at 25°C, applying atmospheric pressure of 0.5 MPa. Additionally, in order to improve the strength of the bond, heat treatment was done at 200°C in an N₂ atmosphere for 2 hours.

Next, the substrate being the H-ion implanted GaN substrate bonded together with the SiO₂/Si template substrate was heat treated at 800°C in an N₂ gas atmosphere for 1 hour, so as to split the H ion implanted GaN substrate in the H ion implantation region (second region), thereby obtaining a GaN layer-bonded substrate in which a 0.8-µm-thick GaN layer was bonded to the SiO₂/Si template substrate (heterosubstrate).

The above-noted second region, and first region outside of the second region, in the GaN layer of the GaN layer-bonded substrate obtained as noted above were subjected to AES, wherein [(Ga/N)₂]/[(Ga/N)₁] was 1.36, [(Ga)₂]/[(Ga)₁] was 1.14, and [(N)₂] /[(N)₁] was 0.84.

That is, it was found that, by using a GaN substrate in which [(Ga/N)₂]/[(Ga/N)₁] was at least 1.05, and more preferably [(Ga)₂]/[(Ga)₁] was at least 1.05 or [(N)₂] /[(N)₁] is 0.94 or less, a GaN layer-bonded substrate was obtained with ease of machining.

### Example 6

Referring to FIG. 4, a semiconductor device A was manufactured using the GaN layer-bonded substrate manufactured in Example 5. That is, MOCVD was used to grow onto the GaN layer 20a of the GaN layer-bonded substrate 1, as a Group III nitride semiconductor epitaxial layer 30, a 5-µm-thick *n*-type GaN layer 31, a 0.5-µm-thick *n*-type Al_{0.05}Ga_{0.95}N layer (n-type AlₛGa₁₋ₛN layer 32), a 100nm-thick light-emitting layer 33 with a MQW (multi-quantum well) formed by six pairs of In_{0.15}Ga_{0.85}N layers and In_{0.01}Ga_{0.99}N layers, a 20-nm-thick *p*-type Al_{0.20}Ga_{0.80}N layer (*p*-type AlₜGa₁₋ₜN layer 34), and a 0.15-µm-thick *p*-type GaN layer 35 in that order. Next, mesa etching was done to expose a part of the surface of the *n*-type GaN layer 31. Next, vacuum evaporation deposition or electron beam deposition was done to form a *p*-side electrode 51 on the *p*-type GaN layer 35 and form an *n*-side electrode 52 on the exposed surface of the *n*-type GaN layer 31.

For the purpose of comparison, a typical semiconductor device R was also manufactured, as follows. Referring to FIG. 5, first MOCVD was used to form a 50-nm-thick AlN buffer layer (Group III nitride buffer layer 3) on a sapphire substrate (heterosubstrate 10), with other features being the same as the above-noted semiconductor device A, a Group III nitride semiconductor epitaxial layer 30 and *p*-side electrode 51 and *n*-side electrode 52 being formed.

With regard to the above-noted semiconductor devices A and R, upon measurement of the spectral light-emission intensity at a peak wavelength of 450 nm with an implantation current of 80 mA using EL (electroluminescence), the relative emission spectral intensity of the semiconductor device A with respect to the emission intensity from the semiconductor device R was 1.22. From this, it was verified that a semiconductor device having superior characteristics was obtained by using a GaN layer-bonded substrate having a GaN layer with high crystallinity.

The embodiments disclosed herein are in all respects exemplary and should be regarded as non-restrictive. The scope of the present invention is indicated by the scope of the claims, and it is intended that all variations that are equivalent in meaning and scope to the claims are encompassed.

### Reference Symbol List

- 1: GaN layer-bonded substrate
- 3: Group III nitride semiconductor buffer layer
- 10: Heterosubstrate
- 20: GaN substrate
- 20a: GaN layer
- 20b: Remaining GaN substrate
- 20i: Second region
- 20j: First region
- 20m: Major surface
- 30: Group III nitride semiconductor epitaxial layer
- 31: *n*-type GaN layer
- 32: *n*-type AlₛGa₁₋ₛN layer
- 33: Light-emitting layer
- 34: *p*-type AlₜGa₁₋ₜN layer
- 35: *p*-type GaN layer
- 51: *p*-side electrode
- 52: *n*-side electrode

## Claims

1. A GaN substrate comprising:
a first region; and
a second region having a higher Ga/N atomic ratio than that of the first region;
wherein
the second region widens from a depth *D -* Δ*D* to a depth *D* + Δ*D* centered about a predetermined depth *D* from one of the substrate's major surfaces, and the difference between the Ga/N atomic ratio at the depth *D* and the Ga/N atomic ratio at a depth *D* + 4Δ*D* or greater in the first region is three times the difference between the Ga/N atomic ratio at the depth *D* + Δ*D* and the Ga/N atomic ratio at the depth *D* + 4Δ*D* or greater in the first region, and
the ratio of the Ga/N atomic ratio in the second region to the Ga/N atomic ratio at the depth *D* + 4Δ*D* or greater in the first region is at least 1.05.

2. The GaN substrate according to claim 1, wherein the ratio of the Ga atomic fraction in the second region to the Ga atomic fraction at the depth *D* + 4Δ*D* or greater in the first region is at least 1.05.

3. The GaN substrate according to claim 1, wherein the ratio of the N atomic fraction in the second region to the N atomic fraction at the depth *D* + 4Δ*D* or greater in the first region is 0.94 or lower.

4. The GaN substrate according to any one of claims 1 to 3, wherein the Ga atomic fraction and the N atomic fraction in the second region differ from the corresponding Ga atomic fraction and N atomic fraction at the depth *D* + 4Δ*D* or greater in the first region.

5. The GaN substrate according to any one of claims 1 to 4, wherein the second region includes ions or atoms of an element other than Ga or N, or electrons.

6. The GaN substrate according to any one of claims 1 to 5, wherein the second region is a strained region having crystal strain, wherein the substrate is split in the second region by the application of external energy.

7. The GaN substrate according to claim 6, wherein the energy is at least one of thermal energy, electromagnetic wave energy, light energy, dynamic energy, and fluid energy.

8. A method of manufacturing a GaN substrate that includes a first region a second region having a higher Ga/N atomic ratio than that of the first region, wherein:
through one of the substrate's major-surface sides ions, atoms or electrons are implanted, or laser light is irradiated to form a second region widening from a depth *D* - Δ*D* to a depth *D* + Δ*D* about a center of a predetermined depth *D* from the major surface, and having a Ga/N atomic ratio that is at least 1.05 times the Ga/N atomic ratio prior to the implantation or irradiation.

9. The method of manufacturing a GaN substrate according to claim 8, wherein the ratio of the Ga atomic fraction in the second region to the Ga atomic fraction prior to the implantation or irradiation is 1.05 or greater.

10. The method of manufacturing a GaN substrate according to claim 8, wherein the ratio of the N atomic fraction in the second region to the N atomic fraction prior to the implantation or irradiation is 0.94 or lower.

11. The method of manufacturing a GaN substrate according to any one of claims 8 to 10, wherein the Ga atomic fraction and the N atomic fraction in the second region differ from the corresponding Ga atomic fraction and N atomic fraction prior to either the implantation or irradiation.

12. A method of manufacturing a GaN layer-bonded substrate, being a GaN layer-bonded substrate in which a GaN layer and a heterosubstrate having a chemical composition different from that of the GaN layer are bonded together, comprising:
a first step of preparing a GaN substrate according to any of claims 1 to 7;
a second step of bonding the heterosubstrate to the major surface of the GaN substrate; and
a third step of obtaining a GaN layer-bonded substrate by splitting the GaN substrate in the second region to form bonded thereto a GaN layer atop the heterosubstrate.

13. A method of manufacturing a semiconductor device comprising:
a step of preparing a GaN layer-bonded substrate obtained by the manufacturing method according to claim 12; and
a step of forming, on the GaN layer of the GaN layer-bonded substrate, an at least single-lamina III nitride semiconductor epitaxial layer.
